# EUROPEAN PATENT SPECIFICATION

(11) **EP 0 612 781 B1**
(45) Date of publication and mention of the grant of the patent: **22.05.2002**
(21) Application number: 93102732.0
(22) Date of filing: 21.02.1993
(51) Int. Cl.: C08G 69/48, C08L 63/00, C08G 81/02, C08G 59/12, C08G 59/28, C08L 77/06

(54) **Epoxy-terminated polyamides, adhesive made therefrom and methods for producing them**
Polyamide mit Epoxyendgruppen, daraus hergestellte Klebstoffe und Verfahren zu ihrer Herstellung
Polyamides à fonctions époxydes terminales, adhésif obtenu à partir de ceux-ci et procédé pour leur production

(43) Date of publication of application: 31.08.1994
(73) Proprietor: KANEGAFUCHI KAGAKU KOGYO KABUSHIKI KAISHA, Kita-ku Osaka-shi (JP)
(72) Inventor: Nojiri, Hitoshi, Ohtsu-shi, Shiga-ken (JP); Yabuta, Katsunori, Ohtsu-shi, Shiga-ken (JP)
(74) Representative: Gille Hrabal Struck Neidlein Prop Roos

(56) References cited:
- EP-A- 0 027 852
- EP-A- 0 174 225
- EP-A- 0 295 906
- EP-A- 0 441 545
- EP-A- 0 527 548
- DE-A- 2 147 205
- US-A- 3 558 742
- US-A- 3 678 127
- US-A- 4 673 723
- US-A- 5 055 530

## Description

The present invention relates to an epoxy-terminated polyamide and an adhesive made therefrom. More particularly, the present invention relates to an epoxy-terminated polyamide, an adhesive made from it, and to methods for producing them. The epoxy-terminated polyamide of the present invention is suited for an amide component and well compatible with an epoxy resin in the production of an epoxy/polyamide adhesive which is excellent in adhesiveness and thermal resistant property and which is usefully available for substrates of flexible printed wiring boards mounting a variety of electric and electronic parts.

Conventionally, an epoxy-polyamide (nylon) type is well known for an adhesive which is excellent in adhesion and thermal resistant property and which is widely made available for a variety of substrates including flexible wiring boards.

On the other hand, from the viewpoint of excessive hygroscopic property and insufficient thermal resistant property, use of a large amount of a polyamide resin against an epoxy resin is not recommended. Generally, a polyamide resin is not well compatible with an epoxy resin.

Therefore, a blend containing a large amount of an epoxy resin often results in poor uniformity in dried conditions, thus, this degrades reliability on the adhesiveness and obstructs to stabilize product quality.

Therefore, an object of the invention is to provide a novel epoxy-terminated polyamide which is well compatible with an epoxy resin and excellent in thermal resistant property, and also provides a method for producing it.

Another object of the invention is to provide a novel adhesive which is excellent in thermal resistant property and adhesiveness, and also provides a method for producing it.

To solve those problems mentioned above and to enhance freedom of blending a variety of epoxy resins and polyamide resins, inventors have made an extensive study to improve compatibility of polyamide resins with epoxy resins. They finally found out that those technical problems mentioned above could be solved by epoxy-terminated polyamides having a specific structure.

The first aspect of the present invention is to provide a novel epoxy-terminated polyamide having the following structure: 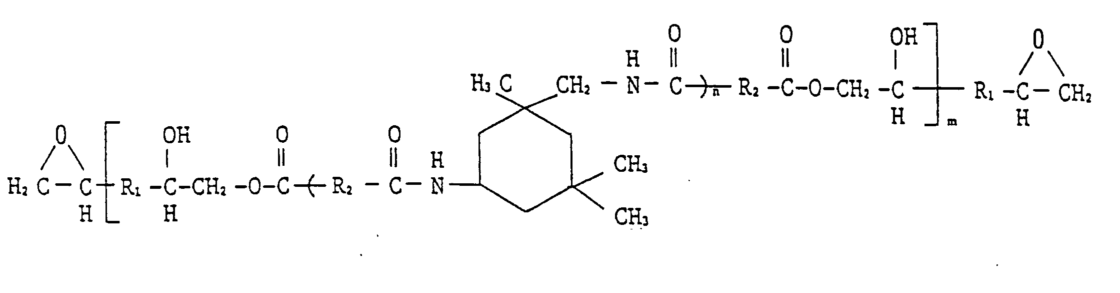 where each of R₁, R₂, and R₃ is a divalent organic group, each of n and m is a natural number of at least 1.

The second aspect of the present invention is to provide a method for producing a novel epoxy-terminated polyamide characterized by reacting an epoxy resin with the carboxylic acid-terminated polyamide.

The third aspect of the present invention is to provide a novel adhesive comprising the aforementioned epoxy-terminated polyamide, an epoxy resin which is different from the epoxy-terminated polyamide resin having a structure identical to or different from that of the epoxy resin used for the preparation of the epoxy-terminated polyamide resin, and curing agent for the epoxy resin.

The fourth aspect of the present invention is to provide a method for producing the above-identified adhesive comprising (1) an epoxy-terminated polyamide resin generated from the reaction of an epoxy resin with a carboxylic acid-terminated polyamide, (2) an epoxy resin having a structure identical to or different from that of the epoxy resin used for the preparation of the epoxy-terminated polyamide resin, and (3) a curing agent for the epoxy resin.

Characteristically, the present invention uses a polyamide resin containing epoxy groups at its terminals, which results in the improved compatibility of the polyamide resin with the epoxy resin so that both the epoxy resin and the polyamide resin can be used in combination with each other at a broader blend ratio, thus expanding freedom for designing physical properties. Furthermore, since the polyamide terminals contain reactive groups, high quality adhesives having very high thermal resistant property can be obtained by the present invention.

The polyamide used in the present invention employs as a monomer dicarboxylic acid such as adipic acid, sebacic acid, dodecan diacid, dimer acid. These acids may be used singly or in combination of two or more. Of these, the dimer acid generates a polyamide containing low hygroscopic property, and is thus preferred. Meanwhile, a polyamide obtained by the use of the dimer acid is extremely poor in compatibility to epoxy resins, and thus, the present invention is capable of producing an epoxy-terminated polyamide which has both low hygroscopic property and excellent compatibility to epoxy resins. Insofar as unsaturated fatty acids are used as raw materials, any kind of dimer acids may be used, including monomer acids or trimer acids. The dimer acid may also be a hydrogenated dimer acid with saturated double bonds. In the light of excellent thermal resistant property and anti-hygroscopic property diamines and diisocyanates (isophorone diisocyanates and diamines) having the structure shown below are used 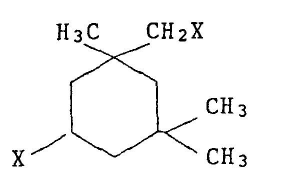 where X is NH₂ or NCO.

That is, the obtained polyamide has the following structure in its molecular structure:

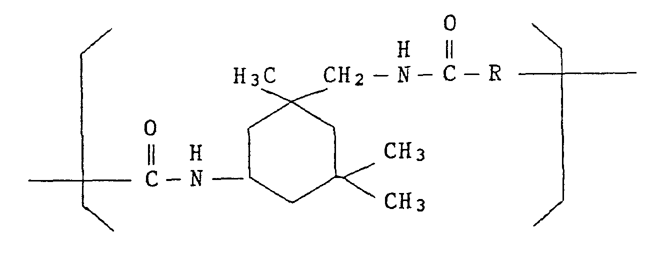

The polyamide desirably has a molecular weight of 1000 - 30000. If the molecular weight is below 1000, flexibility as polyamide is not fully provided. Conversely, if the molecular weight is in excess of 30000, epoxidizing the carboxylic acid-terminated polyamide becomes difficult, resulting in poor compatibility with the epoxy resin.

As regards the epoxy resin reacted with a polyamide, a variety of epoxy resins may be used, including bisphenol A-type epoxy resins, bisphenol F-type epoxy resins, phenol-novolak type epoxy resins, cresol-novolak type epoxy resins, glycidyl ether type epoxy resins, naphthalene-type epoxy resins. However, in order to properly control the reaction, it is preferred to use bifunctional epoxy resins containing two epoxy groups in each molecule. These epoxy resins may be used singly or in combination of two or more.

Furthermore, the epoxy resin reacted with the carboxylic acid terminated polyamide may have a composition identical to or different from the compatible epoxy resin which makes up the main component of the adhesive of the present invention. However, in order to enhance the compatibility with each other, it is desired that the epoxy resins contain a composition being similar to each other.

It is desired that the reaction ratio between the polyamide and the epoxy resin reacted therewith ranges from 1 : 2 to 30 : 31. If the reaction ratio exceeds 30 : 31, the reaction hardly takes place. Furthermore, this causes the molecular weight to be too high, which lowers compatibility and solubility of the polyamide with the epoxy resin to merely result in difficult handling.

The carboxylic acid-terminated polyamide is generated by a conventional method from isophorone diamine by adding the diamine to carboxylic acid. On the other hand, the carboxylic acid-terminated polyamide is generated from isophorone diisocyanate by adding the diisocynate to carboxylic acid in the presence of an organic solvent like N-methylpyrrolidone (NMP) or dimethylformamide (DMF), then conducting the reaction under heated conditions.

The epoxy-terminated polyamide is generated by adding an epoxy resin to carboxylic acid-terminated polyamide in an amount substantially equivalent to that of carboxylic acid of the polyamide in the presence of an organic solvent like toluene, chlorobenzene, or N-methyl-2-pyrrolidone, then conducting the reaction under heated conditions. The natural number n is in a range of from 1 to 40 and the other natural number m is in a range of from 1 to 30 in the above mentioned structure.

When using an amine-terminated polyamide, a secondary amine generated from the reaction with the epoxy resin reacts further with the epoxy resin to generate a tertiary amine which accelerates the reaction between the epoxy resin and the amine to merely complicate the reaction beyond control. To avoid this, it is essential that carboxylic acid-terminated polyamides are used for synthesizing the epoxy-terminated polyamides.

The adhesive of the present invention comprises the above-mentioned epoxy-terminated polyamide resin blended with a suitable amount of an epoxy resin and a curing agent for the epoxy resin. The prefered blend ratio is 10 - 70 parts by weight of the epoxy-terminated polyamide resin and 90 - 30 parts by weight of the epoxy resin. The curing agent is added in an effective amount depending on the kind of the epoxy resin and curing agent. If the epoxy-terminated polyamide resin is less than 10 parts by weight, the resultant adhesive is devoid of flexibility. On the other hand, if it exceeds 70 parts by weight, adhesiveness at a high temperature is degraded.

The curing agent for epoxy resins is not particularly limited, for example, including aliphatic polyamines, aromatic polyamines, secondary or tertiary amines, organic acid anhydrides, imidazoles, dicyandiamides, polymercaptans, novolak resins. These may be used singly or in combination of two or more.

The adhesive of the present invention may further contain ingredients other than those three components described above, for example, including acrylic resins, phenolic resins, imide resins, rubber-like resins, curing accelerators and curing catalysts for epoxy resins, inorganic and organic fillers. From the viewpoint of workability, it is preferred that those ingredients are dissolved in an organic solvent before use.

It is essential that solvents are capable of dissolving both the epoxy and polyamide resins. The organic solvent includes methyl ethyl ketone, toluene, chlorobenzene, trichlorethylene, methylene chloride, methyl cellosolve, ethyl cellosolve, dimethylformamide, dimethylacetoamide, methanol, ethanol, isopropyl alcohol. These solvents may be optionally mixed according to the composition of the adhesives. For example, mixed solvents of methyl ethyl ketone/isopropyl alcohol being 1 : 1, toluene/methanol being 1 : 1, may be employed.

The present invention will be explained in more detail by way of examples, but the present invention is in no way limited thereto.

In the following description, "parts" and "%" mean "parts by weight" and "% by weight", unless otherwise specified.

### Comparative Example 1

60 parts of an epoxy resin "EPIKOTE 1001" (trade name of YUKA-SHELL EPOXY CO., LTD.), 40 parts of an alcohol-soluble dimer acid polyamide (M.W 2000), 5 parts of dicyandiamide, 120 parts of toluene, and 120 parts of isopropyl alcohol were mixed and adequately stirred to thus prepare an adhesive solution. The so prepared adhesive solution was applied onto a polyimide film to a thickness of 20 µm after drying , and dried at 120°C for 1 minute. The surface of the adhesive was observed with the naked eyes and violent phase separation was found.

Next, a copper foil having a thickness of 35 µm was superposed on the layer of the adhesive and laminated at 120 °C. The laminate was heated at 180 °C for 3 hours to cure the layer of the adhesive to thereby produce a polyimide film/copper foil laminate (FCCL).

In accordance with JIS C-5016, the peeling strength was measured. The peeling strength value noticeably fluctuated between 0.8 - 1.4 kgf/cm at 23 °C but was rated to be 0.5 kgf/cm at 100 °C.

### Comparative Example 2

30 parts of an epoxy resin "EPIKOTE 828" (trade name of YUKA-SHELL EPOXY CO., LTD.), 70 parts of alcohol-soluble dimer acid polyamide (M.W 2000), 3 parts of dicyandiamide, 120 parts of toluene, and 120 parts of isopropyl alcohol were mixed and then adequately stirred to thus prepare an adhesive solution. Next, a polyimide film/copper foil laminate (FCCL) was obtained by the same process as in Comparative Example 1, and the peeling strength was measured. The peeling strength values were 1.5 kgf/cm at 23°C, and 0.5 kgf/cm at 100 °C.

### Example 1

### A: Synthesis of carboxylic acid-terminated polyamide

40 grams of dimer acid (including 1 % of trimer) and 120 grams of NMP were charged into a flask furnished with a stirrer and a reflux condenser and dissolved with stirring. Next, 14 grams of isophorone diisocyanate were added and heated at 100 °C for an hour, 150 °C for 3 hours, and at 200 °C for 2 hours to conduct the reaction. Then, NMP was removed by distillation from the reacted solution to thus synthesize a carboxylic acid-terminated polyamide.

### B: Synthesis of epoxy-terminated polyamide

26 grams of carboxylic acid-terminated polyamide (M.W. 5500) obtained in the above A, 6.0 grams of an epoxy resin "EPIKOTE 1001" (trade name of YUKA-SHELL EPOXY CO., LTD), 120 grams of chlorobenzene, and 2.0 ml of triethylamine were charged into a flask furnished with a stirrer and a reflux condenser, and then refluxed at 140 °C for 10 hours to thus conduct the reaction. Then, chlorobenzene and triethylamine were removed by distillation from the reacted solution to thereby synthesize an epoxy-terminated polyamide.

### C: Preparation of an adhesive

60 parts of an epoxy resin "EPIKOTE 1001", 40 parts of an epoxy-terminated polyamide obtained in the above B, 5. 0 parts of dicyandiamide, 80 parts of toluene, and 80 parts of isopropyl alcohol were mixed and then adequately stirred to thus prepare an adhesive solution. Next, the obtained adhesive solution was applied and dried in the same way as in Comparative Example 1. The surface of the dried adhesive was observed with the naked eyes. It was found uniform and phase separation could not be observed. After obtaining a polyimide film/copper foil laminate in the same way as in Comparative Example 1, peeling strength was measured. It was 2.4 kgf/cm at 23°C, and 1.3 kgf/cm at 100 °C.

### Examples 2 - 4

Except for changes shown in Table 1, a carboxylic acid-terminated polyamide and an epoxy-terminated polyamide were synthesized and an adhesive solution was prepared in the same way as in Example 1. Then, peeling strength was measured as in Example 1.

Table 1 shows the amount (grams) of polyamide and epoxy resin used for synthesizing the epoxy-terminated polyamide in Examples 1 - 4, the amount (grams) of ingredients of adhesive containing the synthesized epoxy-terminated polyamide, and the peeling strength rated at 23 °C and 100 °C.

**Table 1**

| Examples | 1 | 2 | 3 | 4 |
|---|---|---|---|---|
| Synthesis of epoxy-terminated polyamide | | | | |
| Polyamide | | | | |
| M.W. 2000 | | 20 | 39 | |
| M.W. 5500 | 26 | | | |
| M.W. 13000 | | | | 40 |
| Epoxy resin "EPIKOTE 1001" | 6 | 11 | 20 | 6 |

| Composition of adhesive | | | | |
|---|---|---|---|---|
| Epoxy-terminated polyamide | 40 | 40 | 40 | 40 |
| Epoxy resin | | | | |
| "EPIKOTE 1001" | 60 | 50 | 50 | 60 |
| Cresol-Novolak | | 10 | 10 | |
| Dicyandiamide | 5 | 5 | 5 | 5 |

| Peeling strength (kgf/cm) | | | | |
|---|---|---|---|---|
| 23 °C. | 2.4 | 2.6 | 2.8 | 2.5 |
| 100 °C. | 1.3 | 1.6 | 1.7 | 1.6 |

According to the present invention, epoxy-terminated polyamides having an improved compatibility with epoxy resins are provided, and at the same time, adhesiveness and thermal resistant property of epoxy/polyamide adhesives are enhanced.

## Claims

1. An epoxy-terminated polyamide having the following structure: 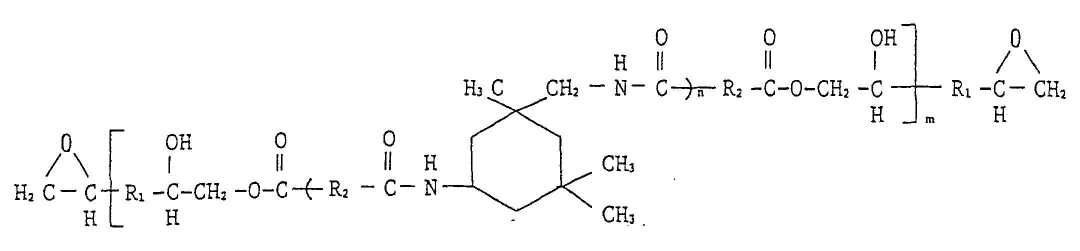 where each of R₁ and R₂ is a divalent organic group, and each of n and m is a natural number of at least 1.

2. The epoxy-terminated polyamide as defined in Claim 1, wherein the polyamide is made from a dimer acid as a raw material.

3. The epoxy-terminated polyamide as defined in Claims 1 or 2, wherein a molecular weight of the polyamide is in a range of from 1000 to 30000.

4. A method for producing an epoxy-terminated polyamide **characterized by** reacting an epoxy resin with a carboxylic acid-terminated polyamide, said polyamide containing the following structure in its molecular structure: 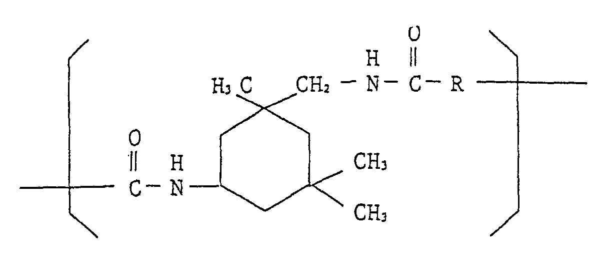 where R is a residual group of a divalent dicarboxylic acid.

5. The method as defined in Claim 4, wherein the polyamide is made from a dimer acid as a raw material.

6. The method as defined in Claims 4 or 5, wherein a molecular weight of the polyamide is in a range of from 1000 to 30000.

7. An adhesive comprising an epoxy-terminated polyamide resin having the following structure : 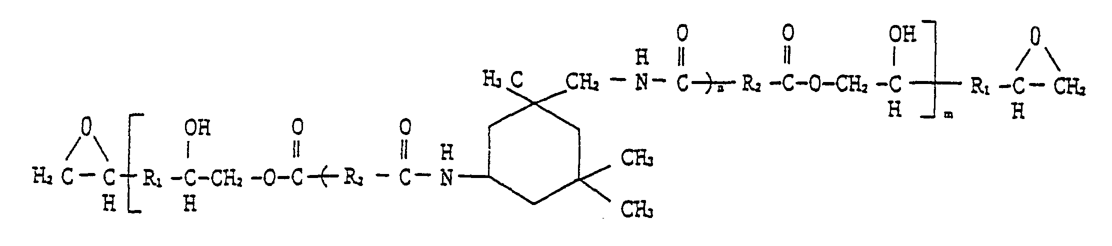 where each of R₁ and R₂ is a divalent organic group, and each of n and m is a natural number of at least 1 , an epoxy resin which is different from the epoxy-terminated polyamide resin having a structure identical to or different from that of the epoxy resin used for the preparation of the epoxy-terminated polyamide resin and a curing agent for the epoxy resin.

8. A method for producing an adhesive as defined in claim 7 **characterized by** mixing an epoxy-terminated polyamide resin, an epoxy resin which is different from the epoxy-terminated polyamide resin having a structure identical to or different from that of the epoxy resin used for the reaction, and a curing agent for the epoxy resin.

## Patentansprüche

1. Polyamid mit Epoxyendgruppen, welches die folgende Struktur hat: 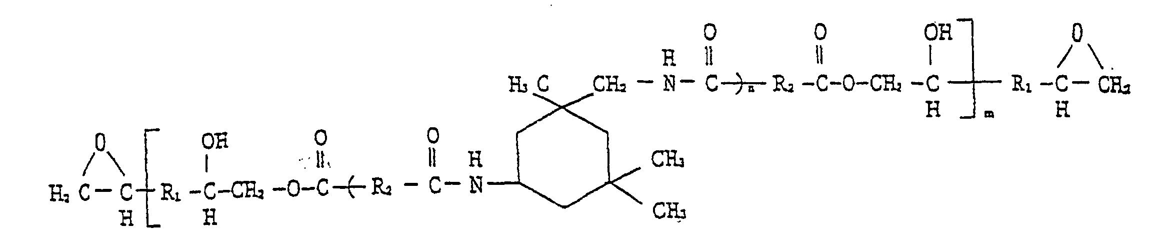 worin R₁ und R₂ jeweils eine divalente organische Gruppe sind, und n und m jeweils eine natürliche Zahl von wenigstens 1 sind.

2. Polyamid mit Epoxyendgruppen nach Anspruch 1, wobei das Polyamid aus einer Dimersäure als Ausgangsmaterial hergestellt ist.

3. Polyamid mit Epoxyendgruppen nach Anspruch 1 oder 2, wobei die relative Molekülmasse des Polyamids in dem Bereich von 1000 bis 30000 liegt.

4. Verfahren zur Herstellung eines Polyamids mit Epoxyendgruppen, **gekennzeichnet durch** die Reaktion eines Epoxyharzes mit einem Polyamid mit Carbonsäure-Endgruppen, wobei das Polyamid die folgende Struktur in seiner Molekülstruktur enthält: 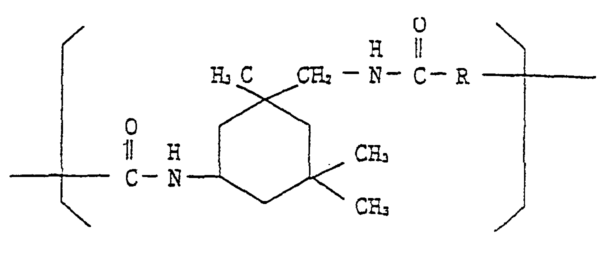 worin R eine Restgruppe einer divalenten Dicarbonsäure ist.

5. Verfahren nach Anspruch 4, wobei das Polyamid aus einer Dimersäure als Ausgangsmaterial hergestellt ist

6. Verfahren nach Anspruch 4 oder 5, wobei die relative Molekülmasse des Polyamids in dem Bereich von 1000 bis 30000 liegt.

7. Klebstoff, umfassend ein Polyamidharz mit Epoxyendgruppen, welches die folgende Struktur hat: 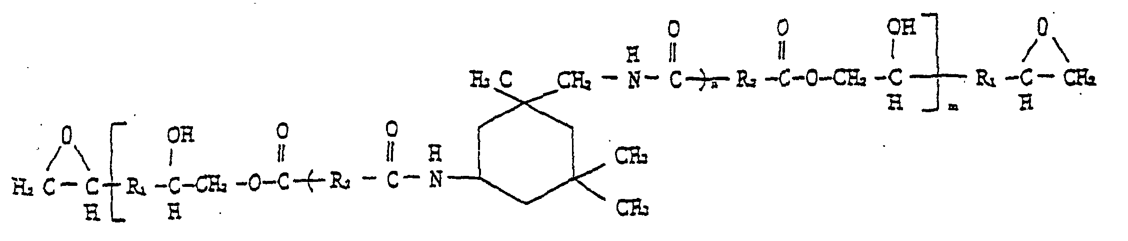 worin R₁ und R₂ jeweils eine divalente organische Gruppe sind, und n und m jeweils eine natürliche Zahl von wenigstens 1 sind,
ein Epoxyharz, welches von dem Polyamidharz mit Epoxyendgruppen verschieden ist und das eine Struktur hat, die identisch zu oder verschieden von der des Epoxyharzes ist, welches für die Herstellung des Polyamidharzes mit Epoxyendgruppen verwendet wird, und
ein Vernetzungsmittel für das Epoxyharz.

8. Verfahren zur Herstellung eines Klebstoffes nach Anspruch 7, **gekennzeichnet durch** Mischen eines Polyamidharzes mit Epoxyendgruppen, eines Epoxyharzes, welches von dem Polyamidharz mit Epoxyendgruppen verschieden ist und das eine Struktur hat, die identisch zu oder verschieden von der des Epoxyharzes ist, welches für die Reaktion verwendet wird, und eines Vernetzungsmittels für das Epoxyharz.

## Revendications

1. Polyamide à terminaison époxy ayant la structure suivante : 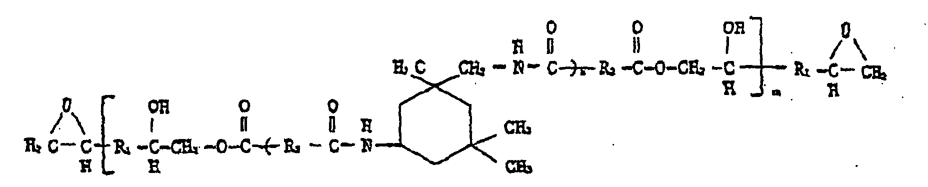 dans laquelle chacun des radicaux R₁ et R₂ est un groupe organique divalent, et chacun des indices n et m est un nombre entier naturel valant au moins 1.

2. Polyamide à terminaison époxy selon la revendication 1, dans lequel le polyamide est obtenu à partir d'un acide dimère en tant que matière première.

3. Polyamide à terminaison époxy selon les revendications 1 ou 2, dans lequel la masse moléculaire du polyamide est comprise dans la plage de 1000 à 30 000.

4. Procédé de production d'un polyamide à terminaison époxy, **caractérisé par** la réaction d'une résine époxy avec un polyamide à terminaison acide carboxylique, ledit polyamide contenant dans sa structure moléculaire la structure suivante : 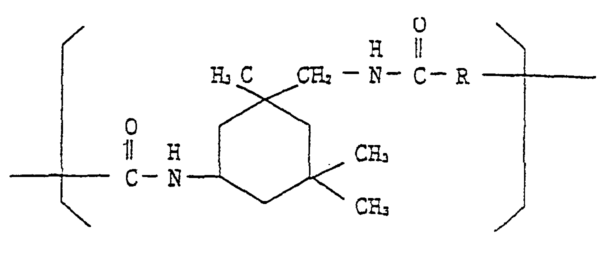 dans laquelle R est le résidu d'un acide dicarboxylique divalent.

5. Procédé selon la revendication 4, dans lequel le polyamide est obtenu à partir d'un acide dimère servant de matière première.

6. Procédé selon les revendications 4 ou 5, dans lequel la masse moléculaire du polyamide est comprise dans la plage de 1000 à 30 000.

7. Adhésif comprenant une résine de polyamide à terminaison époxy ayant la structure suivante : 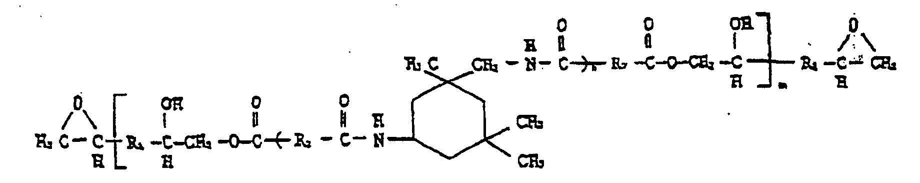 dans laquelle chacun des radicaux R₁ et R₂ est un groupe organique divalent, et chacun des indices n et m est un entier naturel valant au moins 1,
une résine époxy qui est différente de la résiné de polyamide à terminaison époxy, ayant une structure identique à celle de la résine époxy utilisée pour préparer la résine de polyamide à terminaison époxy, ou une structure qui en est différente, et un agent de durcissement pour la résine époxy.

8. Procédé de production d'un adhésif selon la revendication 7, **caractérisé par** le mélange d'une résine de polyamide à terminaison époxy, d'une résine époxy qui est différente de la résine de polyamide à terminaison époxy, et qui a une structure identique à celle de la résine époxy utilisée pour la réaction, ou une structure qui en est différente, et un agent de durcissement pour la résine époxy.
